# EUROPEAN PATENT APPLICATION

(11) **EP 4 718 572 A1**
(43) Date of publication of application: **01.04.2026**
(21) Application number: 25198837.4
(22) Date of filing: 28.08.2025
(51) Int. Cl.: H01M 10/42, H01M 50/105, H05K 1/181, H01M 50/284

(54) **PROTECTION CIRCUIT MODULE AND BATTERY PACK INCLUDING THE SAME**

(30) Priority: 30.09.2024 KR 20240132904
(71) Applicant: SAMSUNG SDI CO., LTD., Yongin-si, Gyeonggi-do 17084 (KR)
(72) Inventor: KOH, Seok, 17084 Yongin-si (KR)
(74) Representative: Marks & Clerk LLP

(57) **Abstract**

A protection circuit module includes: a protection circuit board electrically connected to an electrode tab protruding from one surface of a bare cell, and including a molding member covering one surface of the protection circuit board; a printed circuit board (PCB) on another surface of the protection circuit board opposite to the one surface; and a first spacer coupled with one end of the protection circuit board with respect to a longitudinal direction of the protection circuit board. The protection circuit board includes a first coupling portion coupled with the first spacer, and the first spacer includes a second coupling portion corresponding to the first coupling portion.

## Description

### BACKGROUND

### 1. Field

Aspects of embodiments of the present disclosure relate to a protection circuit module, and a battery pack including the protection circuit module.

### 2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

A protection circuit module (PCM) in a secondary battery may protect a battery from an overcharge, an over-discharge, or an over-current. The protection circuit module may prevent the battery from igniting or exploding by blocking a flow of a current when an internal temperature or a voltage of the battery rises.

The above information disclosed in this Background section is for enhancement of understanding of the background of the present disclosure, and therefore, it may contain information that does not constitute related (or prior) art.

### SUMMARY

Embodiments of the present disclosure may be directed to a protection circuit module, and a battery pack including the protection circuit module.

These and other aspects and features of the present disclosure will be described in or will be apparent from the following description of embodiments of the present disclosure.

According to one or more embodiments of the present disclosure, a protection circuit module includes: a protection circuit board electrically connected to an electrode tab protruding from one surface of a bare cell, and including a molding member covering one surface of the protection circuit board; a printed circuit board (PCB) on another surface of the protection circuit board opposite to the one surface; and a first spacer coupled with one end of the protection circuit board with respect to a longitudinal direction of the protection circuit board. The protection circuit board includes a first coupling portion coupled with the first spacer, and the first spacer includes a second coupling portion corresponding to the first coupling portion.

In an embodiment, the first coupling portion may include a projection having a protruding shape, and the second coupling portion may include an accommodation portion having a groove shape for accommodating the first coupling portion.

In an embodiment, the second coupling portion may include a projection having a protruding shape, and the first coupling portion may include an accommodation portion having a groove shape for accommodating the second coupling portion.

In an embodiment, the first coupling portion and the second coupling portion may be bonded to each other at a portion where the first coupling portion and the second coupling portion contact each other.

In an embodiment, the printed circuit board may include an extension portion protruding beyond one end of the protection circuit board with respect to the longitudinal direction of the protection circuit board.

In an embodiment, the first spacer may be located on the extension portion.

In an embodiment, the first spacer may fill at least a part of a space of a stepped portion between the printed circuit board and the protection circuit board.

In an embodiment, a thickness of the first spacer may correspond to a thickness of the protection circuit board.

In an embodiment, the protection circuit module may further include a second spacer coupled with another end of the protection circuit board with respect to the longitudinal direction of the protection circuit board. The protection circuit board may include a third coupling portion coupled with the second spacer, and the second spacer may include a fourth coupling portion corresponding to the third coupling portion.

In an embodiment, the second spacer may be located on a protrusion of a pouch outer case protruding from the bare cell.

The second spacer may fill at least a part of a space of a stepped portion between the protrusion of the pouch outer case and the protection circuit board.

In an embodiment, the second spacer may include an inclined portion to avoid an interference with an overlapping region at an end of a side surface of a protrusion of a pouch outer case protruding from the bare cell.

In an embodiment, a thickness of the second spacer may correspond to a coupling thickness of the protection circuit board and the printed circuit board.

In an embodiment, the first coupling portion may be injection-molded into the molding member, and the second coupling portion may be injection-molded into the first spacer.

In an embodiment, a position of the first spacer may be fixed as the first spacer and the protection circuit board are coupled to one another.

According to one or more embodiments of the present disclosure, a battery pack includes: a bare cell; a protection circuit module (PCM) electrically connected to the bare cell; and a fixing tape covering the protection circuit module and at least a part of the bare cell. The protection circuit module includes: a protection circuit board electrically connected to an electrode tab protruding from one surface of the bare cell, and including a molding member covering one surface of the protection circuit board; a printed circuit board (PCB) on another surface of the protection circuit board opposite to the one surface; and a first spacer coupled with one end of the protection circuit board with respect to a longitudinal direction of the protection circuit board. The protection circuit board includes a first coupling portion coupled with the first spacer, and the first spacer includes a second coupling portion corresponding to the first coupling portion.

In an embodiment, the first coupling portion may include a projection having a protruding shape, and the second coupling portion may include an accommodation portion having a groove shape for accommodating the first coupling portion.

In an embodiment, the second coupling portion may include a projection having a protruding shape, and the first coupling portion may include an accommodation portion having a groove shape for accommodating the second coupling portion.

In an embodiment, the first coupling portion and the second coupling portion may be bonded to each other at a portion where the first coupling portion and the second coupling portion contact each other.

In an embodiment, the printed circuit board may include an extension portion protruding beyond one end of the protection circuit board with respect to the longitudinal direction of the protection circuit board, and the first spacer may be located on the extension portion.

In an embodiment, the first spacer may fill at least a part of a space of a stepped portion between the printed circuit board and the protection circuit board.

In an embodiment, a thickness of the first spacer may correspond to a thickness of the protection circuit board.

In an embodiment, the battery pack may further include a second spacer coupled with another end of the protection circuit board with respect to the longitudinal direction of the protection circuit board. The protection circuit board may include a third coupling portion coupled to the second spacer, and the second spacer may include a fourth coupling portion corresponding to the third coupling portion.

In an embodiment, the battery pack may further include a pouch outer case covering a surface of the bare cell. The pouch outer case may include a protrusion protruding toward the protection circuit module, and the second spacer may include an inclined portion to avoid an interference with an overlapping region at an end on a side surface of the protrusion.

According to some embodiments of the present disclosure, in the battery pack to which a standardized protection circuit board is applied, the spacers may be disposed in the dead spaces caused by a difference in the size and/or the shape of the battery pack, and thus, the appearance of the battery pack may be standardized.

According to some embodiments of the present disclosure, the spacers and the protection circuit board may be coupled to each other, and thus, the movement of the spacers may be suppressed even though the battery pack is dropped or an impact from the outside is applied to the battery pack.

According to some embodiments of the present disclosure, the spacers may be connected to the protection circuit board without the stepped portion, and thus, a fixing tape attached to the spacers and the protection circuit board may be prevented or substantially prevented from being wrinkled or twisted.

According to some embodiments of the present disclosure, when the standardized protection circuit board is applied to the bare cell designed such that the electrode tab protrudes to be biased to one side, the appearance of the battery pack may be standardized with one spacer (e.g., with only one spacer), and thus, the manufacturing efficiency and economic feasibility of the battery pack may be increased.

According to some embodiments of the present disclosure, the protection circuit module may be stably mounted on the protrusion of the pouch outer case, and an interference of the protection circuit module by the protrusion of the pouch outer case and/or a dog ear of the protrusion may be prevented or substantially prevented.

At least some of the above and other features of the invention are set out in the claims.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is an exploded perspective view of a battery pack according to some embodiments of the present disclosure;
FIG. 2 is a perspective view of a battery pack according to some embodiments of the present disclosure;
FIG. 3 is a plan view illustrating a part of a protection circuit module according to some embodiments of the present disclosure;
FIG. 4 is a side view illustrating a part of the protection circuit module according to some embodiments of the present disclosure;
FIG. 5 is a bottom view illustrating a part of the protection circuit module according to some embodiments of the present disclosure;
FIG. 6 is a perspective view of a battery pack according to some embodiments of the present disclosure;
FIG. 7 is a plan view illustrating a part of a protection circuit module according to some embodiments of the present disclosure;
FIG. 8 is a side view illustrating a part of the protection circuit module according to some embodiments of the present disclosure;
FIG. 9 is a bottom view illustrating a part of the protection circuit module according to some embodiments of the present disclosure;
FIG. 10 is a diagram illustrating an example in which spacers and a protection circuit board are coupled to each other according to some embodiments of the present disclosure;
FIG. 11 is a diagram illustrating an example in which spacers and a protection circuit board are coupled to each other according to some embodiments of the present disclosure;
FIG. 12 is a diagram illustrating an example in which spacers and a protection circuit board are coupled to each other according to some embodiments of the present disclosure;
FIGS. 13 and 14 are diagrams illustrating a protrusion of a pouch outer case according to some embodiments of the present disclosure; and
FIG. 15 is a diagram illustrating an example of a spacer according to some embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Regions illustrated in the drawings may be exaggerated in size and thickness and relative size and thickness for convenience of illustration. As such, the present disclosure is not limited thereto. Throughout the specification, the same reference symbols denote the same or substantially the same components.

As secondary batteries become smaller and thinner, standardized protection circuit modules that may be applied to various batteries are being developed. However, when a protection circuit module manufactured in one shape and size is applied regardless or irrespective of the shape or the size of the secondary battery, a dead space (e.g., an undesirable dead space) may occur at a connection portion between the protection circuit module and the secondary battery.

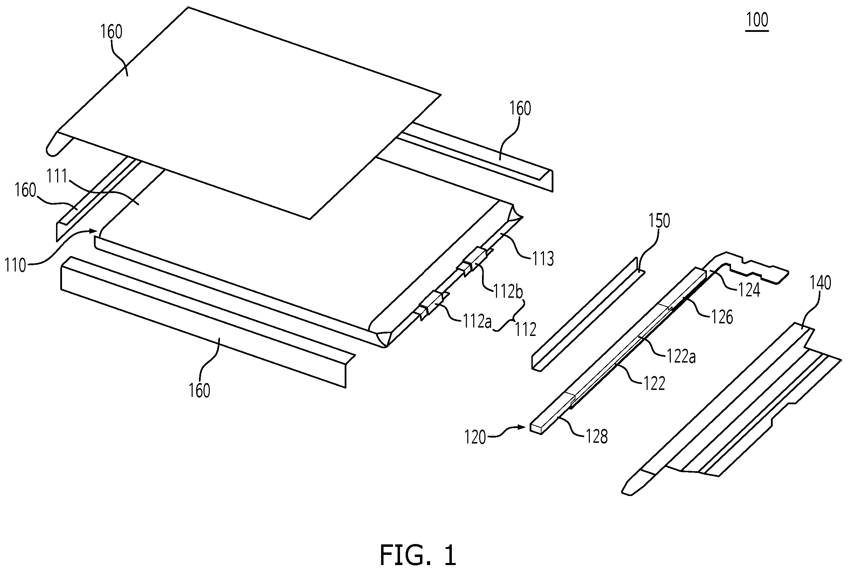

FIG. 1 is an exploded perspective view of a battery pack 100 according to some embodiments of the present disclosure.

Referring to FIG. 1, the battery pack 100 may include a bare cell 110, a protection circuit module 120 electrically connected to the bare cell 110, a fixing tape 140 that fixes the protection circuit module 120 to the bare cell 110, and a cover tape 160 that covers a surface of the bare cell 110.

The bare cell 110 may include an electrode assembly, and a pouch outer case 111 covering a surface of the electrode assembly. The electrode assembly may include a positive electrode plate, a negative electrode plate, and a separator interposed between the positive electrode plate and the negative electrode plate. An electrode tab 112 may protrude from one side of the electrode assembly. For example, a positive electrode tab 112a may protrude from one side of the positive electrode plate, and a negative electrode tab 112b may protrude from one side of the negative electrode plate. The pouch outer case 111 may cover the surface of the electrode assembly, such that the electrode tab 112 is exposed to the outside.

The protection circuit module 120 may play a role in preventing or substantially preventing an over-charge, an over-discharge, and/or an over-current of the bare cell 110. The protection circuit module 120 may include a protection circuit board 122, a printed circuit board 124, and spacers 126, 128.

Electronic components for monitoring and protecting a status of the bare cell 110 may be implemented on the protection circuit board 122. For example, electronic components, such as relays, capacitors, and positive temperature coefficient (PTC) thermistors, may be implemented on the protection circuit board 122. One surface of the protection circuit board 122 may be covered with a molding member 122a to insulate the components implemented on the protection circuit board 122, and protect them from external impacts.

The protection circuit board 122 may be electrically connected to the bare cell 110. For example, the protection circuit board 122 may be electrically connected to the electrode tab 112 protruding from one side of the bare cell 110 through an electrode terminal. In this case, the electrode terminal connected to the positive electrode tab 112a may function as a positive electrode terminal, and the electrode terminal connected to the negative electrode tab 112b may function as a negative electrode terminal.

The printed circuit board 124 may be connected to the protection circuit board 122. For example, the printed circuit board 124 may be disposed on another surface of the protection circuit board 122 opposite to the surface of the protection circuit board 122 covered with the molding member 122a. The printed circuit board 124 may be electrically connected to the protection circuit board 122 by any suitable method, such as brazing or soldering.

In some embodiments, the printed circuit board 124 may be a flexible printed circuit board (FPCB). In some embodiments, the printed circuit board 124 may have various suitable shapes, and thus, a degree of freedom in the design thereof may be higher compared to that of a circuit board made of a rigid material.

In some embodiments, the printed circuit board 124 may be a separate circuit board. For example, the printed circuit board 124 may be manufactured separately from the protection circuit board 122, and may then be connected to the protection circuit board 122 during assembly of the protection circuit module 120. Accordingly, a standardized design of the protection circuit board 122 may be created. For example, the standardized protection circuit board 122 may be applied to various suitable kinds of battery packs 100 by connecting the printed circuit board 124 to the standardized protection circuit board 122, while a design (e.g., only a design) of the printed circuit board 124 may be changed according to the kind of the battery pack 100.

The printed circuit board 124 may include an extension portion. The extension portion may refer to a portion that protrudes beyond one end of the protection circuit board 122 with respect to a longitudinal direction of the protection circuit board 122. A connector may be connected to an end of the extension portion for a connection to an external device.

Each of the spacers 126, 128 may be coupled with (e.g., connected to or attached to) at least one end of the protection circuit board 122 with respect to the longitudinal direction of the protection circuit board 122. For example, the first spacer 126 may be coupled with (e.g., connected to or attached to) one end of the protection circuit board 122, and the second spacer 128 may be coupled with (e.g., connected to or attached to) another end (e.g., an opposite end) of the protection circuit board 122.

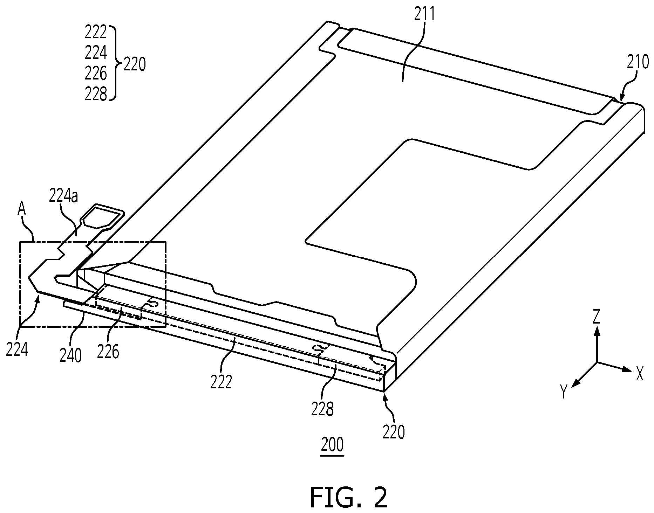

In some embodiments, the first spacer 126 may be disposed on the extension portion of the printed circuit board 124. Accordingly, the first spacer 126 may fill at least a part of a space formed by a stepped portion between the printed circuit board 124 and the protection circuit board 122. Some examples in which the spacers 126, 128 are coupled with (e.g., connected to or attached to) the protection circuit board 122 will be described in more detail below with reference to FIGS. 2 to 12.

The protection circuit module 120 connected to the bare cell 110 may be mounted on one side of the bare cell 110. A protrusion 113 may be formed on one side of the pouch outer case 111 (e.g., in a direction in which the electrode tab 112 protrudes), and the protrusion 113 may provide a space in which the protection circuit module 120 is mounted. For example, an insulating tape 150 may be disposed on the protrusion 113, and the protection circuit module 120 may be mounted on the insulating tape 150.

The fixing tape 140 may fix the protection circuit module 120 to the bare cell 110. The fixing tape 140 may be disposed to cover at least a part of the protection circuit module 120 and at least a part of the bare cell 110. The protection circuit module 120 may be fixed by the fixing tape 140 in a state of being mounted on one side of the bare cell 110. The fixing tape 140 may cover the protection circuit module 120 along a width direction of the bare cell 110 (e.g., in a direction parallel to the longitudinal direction of the protection circuit board 122).

In the battery pack 100 to which the standardized protection circuit board 122 is applied, the spacers 126 and 128 may be disposed in dead spaces (e.g., empty spaces on a side surface of the protection circuit board 122) that may occur due to a difference in a size and/or a shape of the battery pack 100, and thus, an appearance of the battery pack 100 may be standardized.

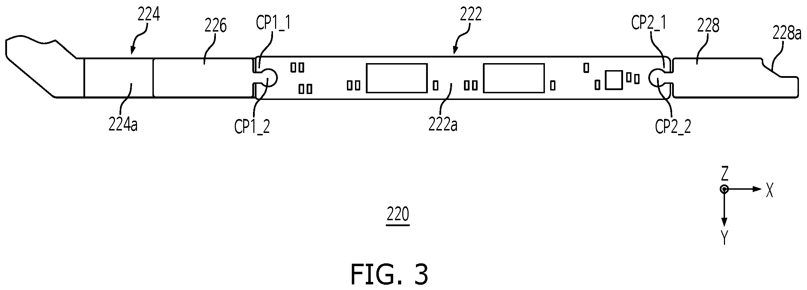

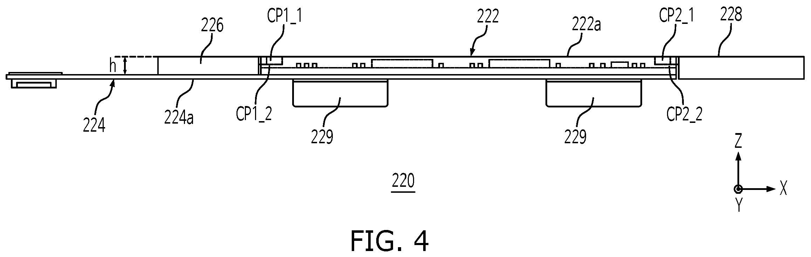

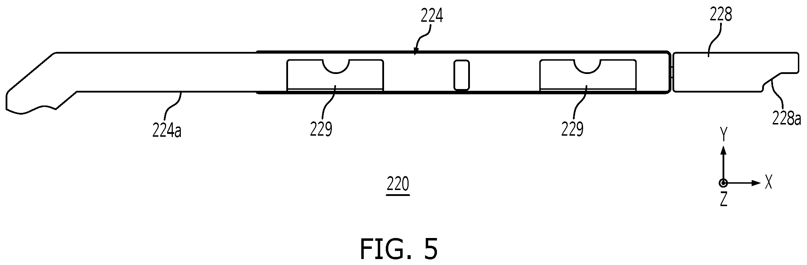

FIG. 2 is a perspective view of a battery pack 200 according to some embodiments of the present disclosure. FIG. 3 is a plan view illustrating a part of a protection circuit module 220 according to some embodiments of the present disclosure. FIG. 4 is a side view illustrating a part of the protection circuit module 220 according to some embodiments of the present disclosure. FIG. 5 is a bottom view illustrating a part of the protection circuit module 220 according to some embodiments of the present disclosure. FIGS. 3 through 5 may be diagrams illustrating examples of various views of a protection circuit module 220 according to some embodiments of the present disclosure.

Referring to FIG. 2, the battery pack 200 may include a bare cell 210, the protection circuit module 220, and a fixing tape 240. The protection circuit module 220 may include a protection circuit board 222 electrically connected to the bare cell 210, a printed circuit board 224 disposed on one surface of the protection circuit board 222, and a first spacer 226 and a second spacer 228 coupled with (e.g., connected to or attached to) both ends (e.g., opposite ends) of the protection circuit board 222. In some embodiments, the first spacer 226 may be disposed on an extension portion 224a of the printed circuit board 224 that protrudes beyond one end of the protection circuit board 222.

The bare cell 210 may include a pouch outer case 211 that covers an outside of the bare cell 210. The pouch outer case 211 may include a protrusion that protrudes in a direction in which an electrode tab of the bare cell 210 protrudes (e.g., the +Y direction). The protection circuit module 220 is mounted on the protrusion of the pouch outer case 211, and the fixing tape 240 may fix the protection circuit module 220 and the bare cell 210 to each other.

In some embodiments, the fixing tape 240 may be disposed to cover the protection circuit module 220 and the bare cell 210 in a width direction of the bare cell 210 (e.g., the X-axis direction). For example, one end of the fixing tape 240 may be positioned on an upper surface of the bare cell 210 (e.g., a surface in the +Z direction), and another end (e.g., an opposite end) of the fixing tape 240 may be positioned on a lower surface of the bare cell 210 (e.g., a surface in the -Z direction).

In some embodiments, a width of the fixing tape 240 may correspond to or substantially correspond to (e.g., may be the same or substantially the same as) a width of the bare cell 210, or may be close to (e.g., similar to) the width of the bare cell 210 with respect to the longitudinal direction of the protection circuit module (e.g., in the X-axis direction). In some embodiments, dead spaces may be formed in a left direction (e.g., the -X direction) and/or a right direction (e.g., the +X direction) of the protection circuit board 222, and the spacers 226, 228 may fill at least a part of the dead spaces. For example, the first spacer 226 disposed on the extension portion 224a of the printed circuit board 224 may fill at least a part of the space (e.g., the dead space) formed by a stepped portion between the printed circuit board 224 and the protection circuit board 222. The second spacer 228 positioned on the protrusion of the pouch outer case 211 may fill at least a part of the space (e.g., the dead space) formed by a stepped portion between the protrusion and the protection circuit board 222.

Referring to FIGS. 3 to 5, the protection circuit module 220 may include the protection circuit board 222, the printed circuit board 224, the first spacer 226, the second spacer 228, and an electrode terminal 229.

One surface of the protection circuit board 222 may be covered with a molding member 222a to protect the electronic components mounted on the protection circuit board 222. In some embodiments, the molding member 222a may include (e.g., may be made of) a suitable material, such as an epoxy resin, polyurethane, a phenol resin, an ultra-violet (UV) curing resin, or the like, but the present disclosure is not limited thereto.

The printed circuit board 224 may be connected to the protection circuit board 222. The printed circuit board 224 may be disposed on another surface (e.g., an opposite surface) opposite to the surface of the protection circuit board 222 covered with the molding member 222a. The printed circuit board 224 may include the extension portion 224a that protrudes beyond one end of the protection circuit board 222 with respect to the longitudinal direction of the protection circuit board 222.

With respect to the longitudinal direction of the protection circuit board 222, the first spacer 226 may be coupled with (e.g., connected to or attached to) the end of the protection circuit board 222, and the second spacer 228 may be coupled with (e.g., connected to or attached to) the other end of the protection circuit board 222. In some embodiments, the protection circuit board 222 includes coupling portions for coupling with the first spacer 226 and the second spacer 228, and each of the first spacer 226 and the second spacer 228 may include a counter coupling portion for the corresponding coupling portion of the protection circuit board 222. For example, the protection circuit board 222 may include a first coupling portion CP1_1 for coupling with the first spacer 226, and the first spacer 226 may include a second coupling portion CP1_2 corresponding to the first coupling portion CP1_1. Similarly, the protection circuit board 222 may include a third coupling portion CP2_1 for coupling with the second spacer 228, and the second spacer 228 may include a fourth coupling portion CP2_2 corresponding to the third coupling portion CP2_1.

In some embodiments, the first spacer 226 may be disposed on the extension portion 224a of the printed circuit board 224. In some embodiments, the first spacer 226 may fill at least a part of a space formed by a stepped portion h between the printed circuit board 224 and the protection circuit board 222. As an example, a thickness of the first spacer 226 may correspond to (e.g., be the same as, similar) a thickness of the protection circuit board 222 (e.g., including the molding member 222a thereon), but the present disclosure is not limited thereto. In other words, the first spacer 226 may be connected to the protection circuit board 222 without the stepped portion with respect to a height direction of the protection circuit board 222 (e.g., the +Z direction).

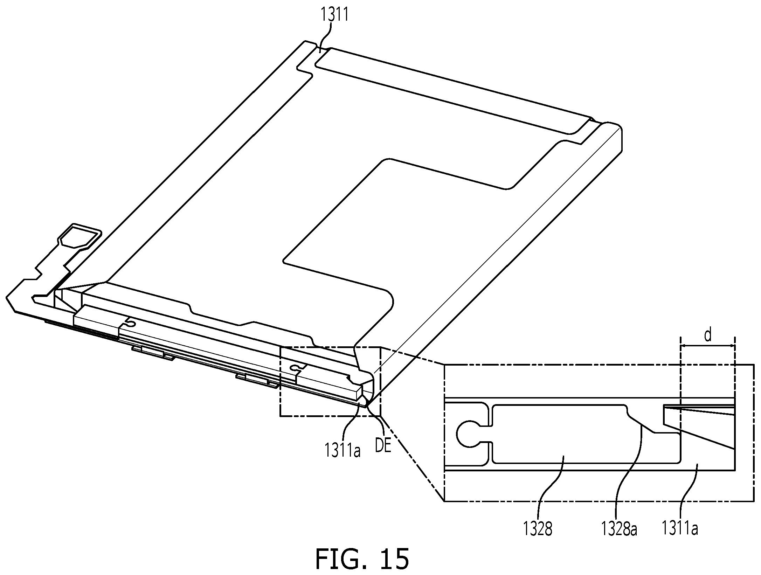

In some embodiments, the second spacer 228 may be disposed in a direction opposite to a protruding direction in which the extension portion 224a protrudes, and may be disposed on the protrusion of the pouch outer case. In some embodiments, the second spacer 228 may include an inclined portion 228a for avoiding an interference with the protrusion of the pouch outer case. An example of the inclined portion 228a of the second spacer 228 will be described in more detail below with reference to FIG. 15.

In some embodiments, the second spacer 228 may fill at least a part of a space formed by a stepped portion between the protrusion of the pouch outer case and the protection circuit board 122. As an example, a thickness of the second spacer 228 may correspond to or substantially correspond to a coupling thickness of the protection circuit board 222 and the printed circuit board 224, but the present disclosure is not limited thereto. In other words, the second spacer 228 may be connected to the protection circuit board 222 without the stepped portion with respect to the height direction of the protection circuit board 222 (e.g., the +Z direction).

The spacers 226, 228 and the protection circuit board 222 may be coupled with (e.g., connected to or attached to) each other, and thus, the movement of the spacers 226, 228 may be suppressed even though the battery pack 200 is dropped or an impact from the outside is applied to the battery pack 200.

In addition, the spacers 226, 228 may be connected to the protection circuit board 222 without the stepped portion with respect to the height direction of the protection circuit board 222, and thus, the spacers 226, 228 and the fixing tape 240 attached to the protection circuit board 222 may be prevented or substantially prevented from being wrinkled or twisted.

In FIGS. 2 to 5, the extension portion 224a of the printed circuit board 224 is illustrated as extending to one side (e.g., to only one side), but the shape of the printed circuit board 224 is not limited thereto. For example, the printed circuit board 224 may protrude from both ends (e.g., opposite ends) of the protection circuit board 222.

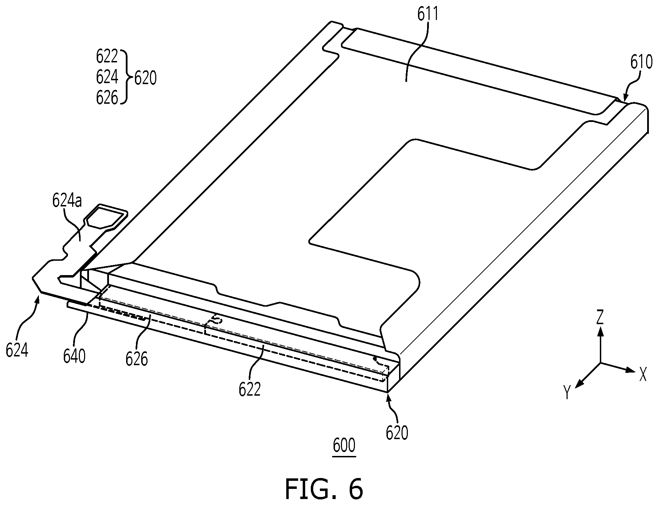

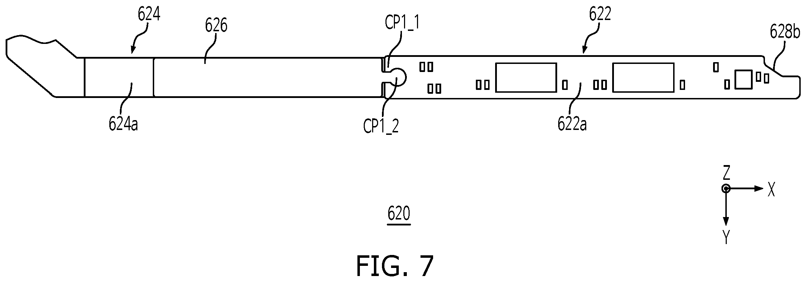

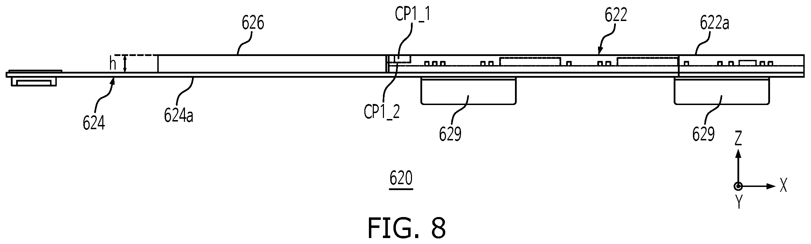

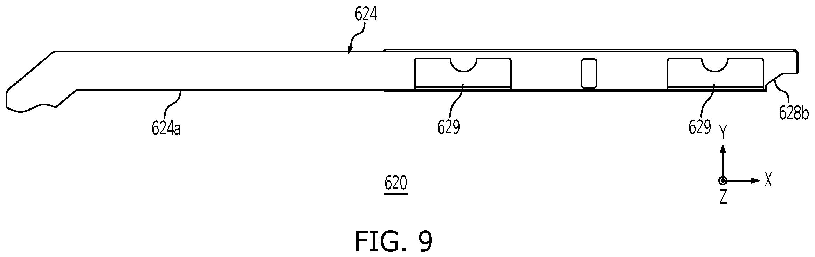

FIG. 6 is a perspective view of a battery pack 600 according to some embodiments of the present disclosure. FIGS. 7 to 9 are diagrams illustrating examples of the protection circuit module 620 according to some embodiments of the present disclosure. FIG. 7 is a plan view illustrating a part of a protection circuit module 620 according to some embodiments of the present disclosure. FIG. 8 is a side view illustrating a part of the protection circuit module 620 according to some embodiments of the present disclosure. FIG. 9 is a bottom view illustrating a part of the protection circuit module 620 according to some embodiments of the present disclosure. Hereinafter with reference to FIGS. 6 to 9, description of the same or substantially the same components and configurations as those described above with reference to FIGS. 1 to 5 may not be repeated, and the differences therebetween may be described in more detail hereinafter.

The battery pack 600 may include a bare cell 610, the protection circuit module 620, and a fixing tape 640. The protection circuit module 620 may include a protection circuit board 622 electrically connected to the bare cell 610, a printed circuit board 624 disposed on one surface of the protection circuit board 622, and a spacer 626 coupled with (e.g., connected to or attached to) one end of the protection circuit board 622. In some embodiments, the spacer 626 may be disposed on an extension portion 624a of the printed circuit board 624 that protrudes beyond one end of the protection circuit board 622.

In some embodiments, the protection circuit module 620 may be disposed to be biased with respect to a width direction of the bare cell 610 (e.g., in the X-axis direction). For example, when an electrode tab protruding from the bare cell 610 protrudes to be biased to one side with respect to the width direction of the bare cell 610, an electrode terminal of the protection circuit module 620 connected to the electrode tab may also be disposed to be biased to one side. In some embodiments, the protection circuit module 620 may also be disposed to be biased to one side with respect to the width direction of the bare cell 610. For example, one end of the protection circuit module 620 may be disposed at a position corresponding to one side surface of the bare cell 610 (e.g., a surface in the +X direction).

The fixing tape 640 may be disposed to cover the protection circuit module 620 and the bare cell 610 in the width direction of the bare cell 610 (e.g., in the X-axis direction). In some embodiments, a width of the fixing tape 640 may correspond to or substantially correspond to a width of the bare cell 610, or may be close to (e.g., similar to) the width of the bare cell 610 with respect to a longitudinal direction of the protection circuit module (e.g., in the X-axis direction). In some embodiments, a dead space may be formed in a left direction of the protection circuit board 622 (e.g., in the -X direction), and the spacer 626 may fill at least a part of the space (e.g., the dead space). For example, the spacer 626 disposed on the extension portion 624a of the printed circuit board 624 may fill at least a part of a space formed by a stepped portion between the printed circuit board 624 and the protection circuit board 622.

Referring to FIGS. 7 to 9, the protection circuit module 620 may include the protection circuit board 622, the printed circuit board 624, the spacer 626, and an electrode terminal 629. The printed circuit board 624 may be disposed on the other surface opposite to the one side of the protection circuit board 622 covered with a molding member 622a. The printed circuit board 624 may include the extension portion 624a that protrudes beyond one end of the protection circuit board 622 with respect to the longitudinal direction of the protection circuit board 622.

The spacer 626 may be coupled with (e.g., connected to or attached to) one end of the protection circuit board 622 with respect to the longitudinal direction of the protection circuit board 622. In this case, the protection circuit board 622 may include a coupling portion for coupling with the spacer 626, and the spacer 626 may include a counter coupling portion for the coupling portion of the protection circuit board 622. For example, the protection circuit board 622 may include a first coupling portion CP1_1 for coupling with the spacer 626, and the spacer 626 may include a second coupling portion CP1_2 corresponding to the first coupling portion CP1_1.

In some embodiments, the spacer 626 may be disposed on the extension portion 624a of the printed circuit board 624. In some embodiments, the spacer 626 may fill at least a part of a space formed by a stepped portion h between the printed circuit board 624 and the protection circuit board 622. As an example, a thickness of the spacer 626 may correspond to a thickness of the protection circuit board 622, but the present disclosure is not limited thereto. In other words, the spacer 626 may be connected to the protection circuit board 622 without a stepped portion with respect to a height direction of the protection circuit board 622 (e.g., the +Z direction).

In some embodiments, when the protection circuit module 620 is disposed to be biased to one side with respect to the width direction of the bare cell 610 (e.g., the X-axis direction), an inclined portion 628b for avoiding an interference with a pouch outer case may be formed at an end of the protection circuit module 620. For example, an edge of the end of the protection circuit module 620 may be partially removed or recessed so as not to interfere with the pouch outer case.

When the standardized protection circuit board 622 is applied to the bare cell 610 having the electrode tab that protrudes to be biased to one side, an appearance of the battery pack 600 may be standardized with only one spacer 626, and thus, a manufacturing efficiency and an economic feasibility of the battery pack 600 may be increased.

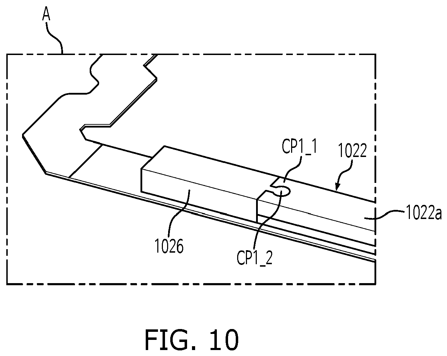

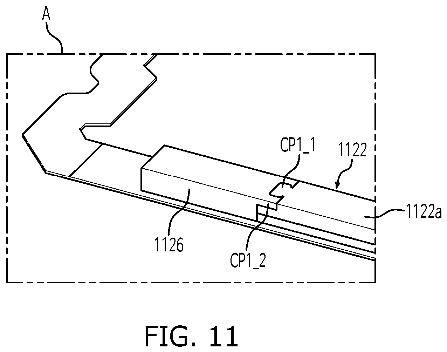

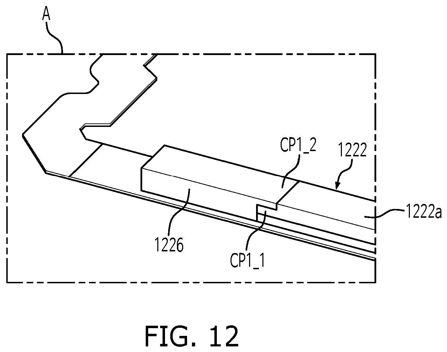

FIGS. 10 to 12 are diagrams illustrating examples in which spacers 1026, 1126, and 1226 and protection circuit boards 1022, 1122, and 1222 according to some embodiments of the present disclosure are coupled to one another. FIG. 10 is a diagram illustrating an example in which a spacer 1026 and a protection circuit board 1022 are coupled to each other according to some embodiments of the present disclosure. FIG. 11 is a diagram illustrating an example in which a spacer 1126 and a protection circuit board 1122 are coupled to each other according to some embodiments of the present disclosure. FIG. 12 is a diagram illustrating an example in which a spacer 1226 and a protection circuit board are coupled to each other according to some embodiments of the present disclosure. FIGS. 10 to 12 may be enlarged partial views of the region A of FIG. 2. Hereinafter, for convenience of illustration, a longitudinal direction of each of the protection circuit boards 1022, 1122, and 1222 may be referred to as a left-right direction, and a thickness direction of each of the protection circuit boards 1022, 1122, and 1222 may be referred to as an up-down direction.

In some embodiments, the spacers 1026, 1126, and 1226 may be coupled with (e.g., connected to or attached to) the protection circuit boards 1022, 1122, and 1222, respectively. For example, each of the protection circuit boards 1022, 1122, and 1222 may include a first coupling portion CP1_1 for coupling with a corresponding one of the spacers 1026, 1126, and 1226, and each of the spacers 1026, 1126, and 1226 may include a second coupling portion CP1_2 corresponding to the corresponding first coupling portion CP1_1.

In some embodiments, as the spacers 1026, 1126, and 1226 and the protection circuit boards 1022, 1122, and 1222 are coupled to one another, a position of each of the spacers 1026, 1126, and 1226 may be fixed on the corresponding protection circuit module. For example, as the first coupling portion CP1_1 of each of the protection circuit boards 1022, 1122, and 1222 and the second coupling portion CP1_2 of each of the spacers 1026, 1126, and 1226 are coupled to one another, the movement of each of the spacers 1026, 1126, and 1226 in the left-right direction and/or the up-down direction may be restricted. The movement of each of the spacers 1026, 1126, and 1226 may be further restricted by the fixing tape (e.g., the fixing tape 240 of FIG. 2) disposed to cover the protection circuit module and the bare cell.

In some embodiments, the first coupling portion CP1_1 may be positioned on each of molding members 1022a, 1122a, and 1222a of the protection circuit boards 1022, 1122, and 1222. For example, the first coupling portion CP1_1 may be injection-molded into each of the molding members 1022a, 1122a, and 1222a. The second coupling portion CP1_2 may be injection-molded into each of the spacers 1026, 1126, and 1226.

Referring to FIG. 10, the second coupling portion CP1_2 of the spacer 1026 may include a projection having a protruding shape, and the first coupling portion CP1_1 of the protection circuit board 1022 may include an accommodation portion formed in a groove shape for accommodating the second coupling portion CP1_2. As an example, the spacer 1026 and the protection circuit board 1022 may be coupled to each other by fitting the second coupling portion CP1_2 of the spacer 1026 into the first coupling portion CP1_1 of the protection circuit board 1022 from above the protection circuit board 1022.

Referring to FIG. 11, the first coupling portion CP1_1 of the protection circuit board 1122 may include a projection having a protruding shape, and the second coupling portion CP1_2 of the spacer 1126 may include an accommodation portion formed in a groove shape for accommodating the first coupling portion CP1_1. As an example, the second coupling portion CP1_2 of the spacer 1126 may accommodate the first coupling portion CP1_1 of the protection circuit board 1122 from above the protection circuit board 1122, and thus, the spacer 1126 and the protection circuit board 1122 may be coupled to each other.

Referring to FIG. 12, the protection circuit board 1222 and the spacer 1226 may be bonded to each other. As an example, after an adhesive is applied to a portion where the first coupling portion CP1_1 of the protection circuit board 1222 and/or the second coupling portion CP1_2 of the spacer 1226 come into contact with each other, the protection circuit board 1222 and the spacer 1226 may be coupled to each other by being press-fitted with each other.

The coupling structures of the protection circuit boards 1022, 1122, and 1222 and the spacers 1026, 1126, and 1226 are not limited to the structures described above with reference to FIGS. 10 to 12, and may be variously modified as needed or desired such that the position of each spacer 1026, 1126, and 1226 may be fixed on each of the protection circuit modules.

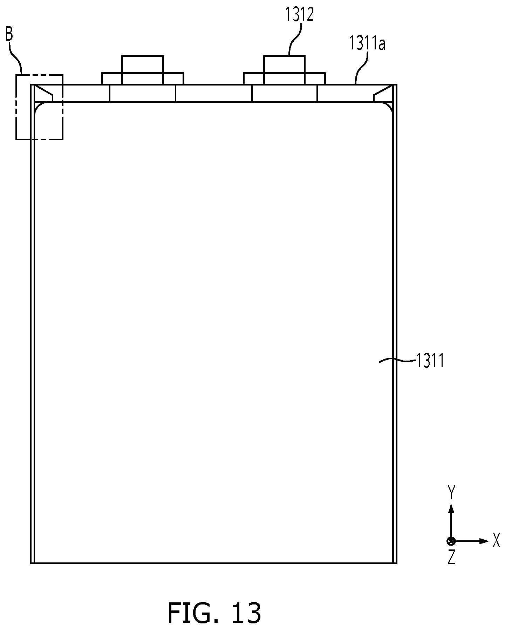

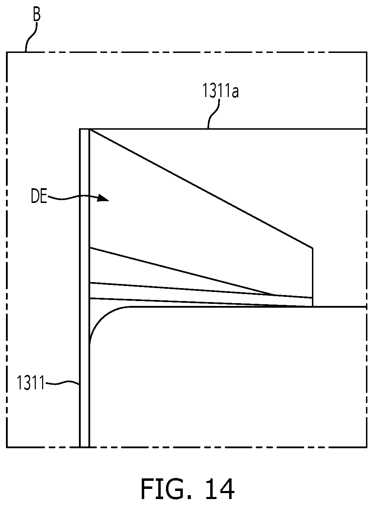

FIGS. 13 and 14 are diagrams illustrating a protrusion 1311a of a pouch outer case 1311 according to some embodiments of the present disclosure. FIG. 14 is an enlarged partial view of the region B of FIG. 13.

Referring to FIGS. 13 and 14, an electrode tab 1312 protrudes from one side of an electrode assembly (e.g., in the +Y direction), and the pouch outer case 1311 may cover a surface of the electrode assembly so that the electrode tab 1312 is exposed to the outside.

In some embodiments, the pouch outer case 1311 may include the protrusion 1311a that protrudes in a direction of the electrode tab 1312 (e.g., in the +Y direction). The protrusion 1311a may provide a space where a protection circuit module is mounted.

As an example, the pouch outer case 1311 may include a first pouch outer case primarily covering a front side of the electrode assembly (e.g., in the +Z direction), and a second pouch outer case primarily covering a rear side of the electrode assembly (e.g., in the - Z direction). The first pouch outer case and the second pouch outer case may be joined to each other along a circumference of the electrode assembly. In some embodiments, at least one of the first pouch outer case or the second pouch outer case may protrude toward the electrode tab 1312 to form the protrusion 1311a.

Dog ears DE may be formed at both ends (e.g., opposite ends) of the protrusion 1311a. The dog ears DE may refer to a folded shape or a folded region in which the pouch outer case 1311 is folded inward at both ends (e.g., opposite ends) of the protrusion 1311a. For example, the dog ear DE may refer to an overlapping region of the pouch outer case 1311 formed at an end of a side surface of the protrusion 1311a. In some embodiments, the protection circuit module mounted on the protrusion 1311a may interfere with the dog ear DE.

FIG. 15 is a diagram illustrating an example of a spacer 1328 according to some embodiments of the present disclosure. Referring to FIG. 15, the spacer 1328 may include an inclined portion 1328a for avoiding an interference with the protrusion 1311a of the pouch outer case 1311 and/or the dog ear DE of the protrusion 1311a. For example, an edge of the end of the spacer 1328 may be partially removed or recessed so as not to interfere with the pouch outer case 1311.

In other embodiments, the spacer 1328 may be spaced apart from (e.g., may be separated from) a side surface of a bare cell to avoid the interference with the pouch outer case 1311. For example, the spacer 1328 may extend to a position that is spaced apart from (e.g., that is separated from) the side surface of the bare cell by a length (e.g., a particular or predetermined length) d. In some embodiments, the length d of the spacer 1328 spaced apart (e.g., separated) from the side surface of the bare cell may be 2.0 mm or less, or 1.0 mm or less, but the present disclosure is not limited thereto.

The protection circuit module according to some embodiments described above may be more stably mounted on the protrusion 1311a of the pouch outer case 1311, and the interference of the protection circuit module by the protrusion 1311a of the pouch outer case 1311 and/or the dog ear DE of the protrusion 1311a may be prevented or substantially prevented.

Although the present disclosure has been described above with respect to embodiments thereof, the present disclosure is not limited thereto. Various modifications and variations can be made thereto by those skilled in the art within the scope of the present disclosure and the equivalent scope of the appended claims.

## Claims

1. A protection circuit module (220, 620), comprising:
a protection circuit board (122, 222, 622, 1022, 1122, 1222) electrically connected to an electrode tab (112, 212, 612, 1312) protruding from one surface of a bare cell (110, 210, 610), and comprising a molding member (122a, 222a, 622a, 1022a, 1122a, 1222a) covering one surface of the protection circuit board (122, 222, 622, 1022, 1122, 1222);
a printed circuit board (PCB) (124, 224, 624) on another surface of the protection circuit board (122, 222, 622, 1022, 1122, 1222) opposite to the one surface; and
a first spacer (126, 226) coupled with one end of the protection circuit board (122, 222, 622, 1022, 1122, 1222) with respect to a longitudinal direction of the protection circuit board (122, 222, 622, 1022, 1122, 1222),
wherein the protection circuit board (122, 222, 622, 1022, 1122, 1222) comprises a first coupling portion (CP1_1) coupled with the first spacer (126, 226), and
wherein the first spacer (126, 226) comprises a second coupling portion (CP1_2) corresponding to the first coupling portion (CP1_1).

2. The protection circuit module according to claim 1,
wherein the first coupling portion (CP1_1) comprises a projection having a protruding shape, and
wherein the second coupling portion (CP1_2) comprises an accommodation portion having a groove shape for accommodating the first coupling portion (CP1_1).

3. The protection circuit module according to claim 1,
wherein the second coupling portion (CP1_2) comprises a projection having a protruding shape, and
wherein the first coupling portion (CP1_1) comprises an accommodation portion having a groove shape for accommodating the second coupling portion (CP1_2).

4. The protection circuit module according to claim 1, 2 or 3, wherein the first coupling portion (CP1_1) and the second coupling portion (CP1_2) are bonded to each other at a portion where the first coupling portion (CP1_1) and the second coupling portion (CP1_2) contact each other.

5. The protection circuit module according to any preceding claim, wherein the printed circuit board (124, 224, 624) comprises an extension portion (124a, 224a, 624a) protruding beyond one end of the protection circuit board (122, 222, 622, 1022, 1122, 1222) with respect to the longitudinal direction of the protection circuit board (122, 222, 622, 1022, 1122, 1222).

6. The protection circuit module according to claim 5, wherein the first spacer (126, 226) is located on the extension portion (124a, 224a, 624a).

7. The protection circuit module according to any preceding claim, wherein the first spacer (126, 226) fills at least a part of a space of a stepped portion between the printed circuit board (124, 224, 624) and the protection circuit board (122, 222, 622, 1022, 1122, 1222).

8. The protection circuit module according to any preceding claim, wherein a thickness of the first spacer (126, 226) corresponds to a thickness of the protection circuit board (122, 222, 622, 1022, 1122, 1222).

9. The protection circuit module according to any preceding claim, further comprising:
a second spacer (128, 228) coupled with another end of the protection circuit board (122, 222, 622, 1022, 1122, 1222) with respect to the longitudinal direction of the protection circuit board (122, 222, 622, 1022, 1122, 1222),
wherein the protection circuit board (122, 222, 622, 1022, 1122, 1222) comprises a third coupling portion (CP2_1) coupled with the second spacer (128, 228), and
wherein the second spacer (128, 228) comprises a fourth coupling portion (CP2_2) corresponding to the third coupling portion (CP2_1).

10. The protection circuit module according to claim 9,
wherein the second spacer (128, 228) is located on a protrusion of a pouch outer case (111, 211, 611, 1311) protruding from the bare cell (110, 210, 610),
and wherein optionally the second spacer (128, 228) fills at least a part of a space of a stepped portion between the protrusion of the pouch outer case (111, 211, 611, 1311) and the protection circuit board (122, 222, 622, 1022, 1122, 1222).

11. The protection circuit module according to claim 9 or 10, wherein the second spacer (128, 228) comprises an inclined portion (1328a) to avoid an interference with an overlapping region at an end of a side surface of a protrusion of a pouch outer case (111, 211, 611, 1311) protruding from the bare cell (110, 210, 610).

12. The protection circuit module according to claim 9, 10 or 11,
wherein a thickness of the second spacer (128, 228) corresponds to a coupling thickness of the protection circuit board (122, 222, 622, 1022, 1122, 1222) and the printed circuit board (124, 224, 624).

13. The protection circuit module according to any preceding claim,
wherein the first coupling portion (CP1_1) is injection-molded into the molding member (122a, 222a, 622a, 1022a, 1122a, 1222a), and
wherein the second coupling portion (CP1_2) is injection-molded into the first spacer (126, 226).

14. The protection circuit module according to any preceding claim,
wherein a position of the first spacer (126, 226) is fixed as the first spacer (126, 226) and the protection circuit board (122, 222, 622, 1022, 1122, 1222) are coupled to one another.

15. A battery pack comprising:
a bare cell (110, 210, 610);
a protection circuit module (220, 620) according to any preceding claim,
wherein the protection circuit module (220, 620) is electrically connected to the bare cell (110, 210, 610); and
a fixing tape (140, 240, 640) covering at least a part of the protection circuit module (220, 620) and at least a part of the bare cell (110, 210, 610).
